(19) Europäisches Patentamt
European Patent Office
Office européen des brevets

(11) **EP 2 589 976 A1**

(12) **EUROPEAN PATENT APPLICATION**

(43) Date of publication:
**08.05.2013 Bulletin 2013/19**

(51) Int Cl.:
**G01R 33/3415** (2006.01)    **G01R 33/36** (2006.01)
**G01R 33/34** (2006.01)

(21) Application number: **12189898.5**

(22) Date of filing: **25.10.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **04.11.2011 CA 2757209**

(71) Applicant: **Imris Inc.**
**Winnipeg, Manitoba R3T 1N5 (CA)**

(72) Inventors:
• **Zhu, Haoqin**
 **Winnipeg, Manitoba, R3T 1N5 (CA)**
• **Wang, Grace Fengqi**
 **Winnipeg, R3T 6E2 (CA)**

(74) Representative: **Jostarndt, Hans-Dieter**
 **Jostarndt Patentanwalts-AG**
 **Brüsseler Ring 51**
 **52074 Aachen (DE)**

(54) **Stacked RF coil for magnetic resonance imaging**

(57)    A receive coil for MRI includes a stacked pair of coil elements to communicate the respective MR signals therein to the signal processing system in separate channels. This greatly increases image SNR and penetration depth and in parallel imaging. The coils are arranged in a stacked relationship so as to be at least partly and preferably wholly overlapped and lying in the same or closely adjacent planes. The coils include tuning capacitors to a common resonant frequency. The coils are connected by a conductor arranged such that the signals of the first and second coils are decoupled. The conductor can form a common portion of the coils including a capacitance of in the common portion arranged. The coils can be connected by two conductors one of which is a short and the other contains a capacitor. In both cases the connection conductors provide the decoupling.

Fig.5

EP 2 589 976 A1

**Description**

This invention relates to Stacked Phase Array Coil for magnetic resonance imaging.

BACKGROUND OF THE INVENTION

As is well known, apparatus for MR imaging of a subject includes an MR magnet to generate a magnetic field to be applied to the subject, an RF transmit coil arrangement for generating an RF pulse in a transmit stage to be applied to the subject to be imaged such that the subject generates an MR signal in response to the magnetic field and the RF pulse applied, a receive coil arrangement for acquiring MR signals in a receive stage and a signal processing system. In recent years phased array surface coils have been used to feed separate signals to a plurality of separate channels for receiving the MR signals for carrying out signal processing in the separate channels by which an image is generated.

Fast MR image technology has been the development of sophisticated multi-element phased array coils which are capable of acquiring multiple channels of data in parallel. This 'parallel imaging' technique uses unique acquisition schemes that allow for accelerated imaging, by replacing some of the spatial coding originating from the magnetic gradients with the spatial sensitivity of the different coil elements. However, the increased acceleration also reduces the signal-to-noise ratio and can create residual artifacts in the image reconstruction. Many parallel acquisition and reconstruction schemes are known.

It is necessary that for phased array coils to operate, decoupling of the signals of the coils must be obtained so that they can be independently processed.

Typically decoupling is obtained by the well known arrangement in which the coils are partly overlapped by a ratio of overlapped to non-overlapped area which acts to decouple the two coils simply by the geometry without any pre-processing of the signals prior to processing in the separate channels of the processing system.

It is known that stacking of coils one on top of the other, or one inside of the other, will provide a very effective arrangement of the phased array coils since they can be of the same size and are located at the same position relative to the sample.

However it is accepted that such stacked coils provide a very strong mutual inductance which prevents decoupling of the signals.

In a paper entitled "Study on the Decoupling of Stacked Phased Array coils for magnetic resonance imaging" by Dandan Liang et al published in Progress in Electromagnetics Research Symposium Proceedings Suzhou China September 12 to 16 2011 there is described a pre-processing system which uses a complex algorithm to perform the post-processing for obtaining the decoupled signals of the stacked coils. Even using this complex algorithm, the coils must be spaced one from the other by a distance greater than 0.5 cms and typically as much as 3.0 cms. This of course significantly reduces the desirability of the stacked arrangement since it is highly desirable to have the coils substantially directly overlying or as close as possible to the same plane. The best advantage is obtained when the coils are in the same plane, or surface if they are not planar, and of the same shape in that plane. However the difficulty of decoupling is reduced when the coils are axially spaced. This paper does not provide actual imaging results, and since actual imaging is more complicated that bench top testing because both pre and post processing of the images is required. Artifacts will most likely result from the pre and post processing of the images.

Current phased array coil designs where the individual coil elements are arranged side by side with partial overlap involves a trade-off between the size of the coil elements and the number of individual elements for a certain overall size of the coil. As the ratio of overlapped portion to non-overlapped portion is set in order to provide the required decoupling, the number of coil elements which can be arranged in a required is dependent on the size of the coil elements.

Current design is also limited by the relationship between coil element size to the penetration achieved since axial penetration of the image is proportional to transverse dimension of the coil.

Current design is also limited by the relationship between coil element size and SNR values. Large size elements produce poor SNR values and small size elements produce good SNR values.

Current imaging design involves a trade-off between image penetration and SNR. In order to achieve good penetration, birdcage volume coils are used because of the uniformity of the RF field in the entire volume of the coil, but do not have good SNR values compared to phased array surface coils. Phased array surface coils have good SNR, but do not have good penetration compared to the birdcage volume coil. To achieve good penetration with the phased array coil, the size of each element has to be increased, but at a sacrifice of good SNR.

The higher the numbers of coil elements in the phase encode direction, the higher the acceleration achieved in parallel imaging.

Current imaging design involves a trade-off between in parallel imaging and SNR, the higher accelerate(R), the more SNR decreased and more image artifact generated. $SNR^{PMRI} = \frac{SNR^{full}}{g\sqrt{R}}$

The stacked array coil can greatly improve the relationship between penetration and SNR and fast imaging.

SUMMARY OF THE INVENTION

It is one object of the invention to provide a stacked array coil which is advantageous in the relationship between penetration and SNR and fast imaging.

According to one aspect of the invention there is provided an apparatus for MR imaging of a subject comprising a MR magnet to generate a magnetic field to be applied to the subject;

an RF transmit coil arrangement for generating an RF pulse in a transmit stage to be applied to the subject to be imaged such that the subject generates an MR signal in response to the magnetic field and the RF pulse applied;

a receive coil arrangement for acquiring MR signals in a receive stage;

and a signal processing system having a plurality of separate channels for receiving the MR signals for carrying out signal processing in the separate channels by which an image is generated;

the receive coil arrangement comprising:

first and second coils arranged to be located adjacent the subject so as to receive the MR signal;

the first and second coils being arranged in a stacked relationship so as to be at least partly overlapped;

said at said first and second coils including tuning capacitors arranged to provide individually tuning of the first and second coils to a common resonant frequency for receiving said MR signal at said common frequency;

each of said first and second coils being arranged to communicate the respective MR signals therein to the signal processing system such that the respective signals are processed in separate channels of the signal processing system;

the first and second coils being connected by a conductor arranged such that the signals of the first and second coils are decoupled.

The first and second coils are arranged to communicate the respective MR signals therein to the signal processing system through either wired and wireless connection.

Each of said first and second coils act only in the receive stage and do not transmit the applied RF pulse in the transmit stage so that they contain therein an arrangement, such as a passive decoupling and active block circuit, to halt current flow therein at the resonant frequency during the transmit stage so as to prevent the presence of said all coil loops from interfering with the RF pulse during the transmit stage. This arrangement is described in more detail in the application mentioned immediately below.

This stacked element coil design can be used for both inductive wireless coil, as disclosed in Application Serial Number 13/090816 filed April 20 2011, and can be used for traditional phased array coil designs with cables and preamplifiers.

While the invention is defied herein as using first and second coils in the stacked arrangement, additional coil elements greater than the two defined can be used in some cases. However of course this increases the complexity of the arrangements for decoupling and tuning each of the coil elements.

The conductor connected between the first and second coils is arranged to effect the decoupling by cancelling mutual inductance therebetween.

Preferably the first and second coils comprise surface coils. However designs can be provided for volume coils using the concepts described herein.

Preferably the first and second coils lie substantially in a common surface. In some cases the surface maybe planar, but in other cases is may be curved or shaped to follow the required shape of the subject, such as an arch over the upper body of the patient.

The intention is that the first and second coils are shaped to define substantially the same transverse dimensions for same depth penetration. However there may be a difference in shape which can be used to decrease capacitive connection between the coils, bearing in mind that the selection of spacing is a trade-off in regard to decoupling and capacitive coupling in relation to improved signal processing.

In a preferred arrangement, the first and second coils are arranged so that one lies inside the other as this allows them to lie in a common plane without increasing the capacitive coupling therebetween to a level which cannot be tolerated.

For the same reason, the first and second coils are preferably of different shape in plan so that the conductors thereof do not follow the same path.

In another preferred arrangement, the first and second coil elements are each formed by conductors which are formed of a wire as opposed to the conventional flat strip. That is the wire has substantially same height as width as opposed to the conventional flat strip which has very little height. This arrangement acts to reduce capacitive connection between the two coil elements in relation to two overlying strips so that the spacing between the two coils can be reduced, even to a situation where they are directly overlying.

The above arrangements allow the coil elements to lie in the same plane or in planes with sufficient isolation to prevent physical contact between the individual coil elements with almost no restriction of the axial spacing, as opposed to the arrangement of the above paper where decoupling can only be obtained by increased axial spacing. If the first coil element is contained entirely inside the second coil element, no axial separation is required.

In one arrangement, the conductor connecting the first and second coil elements provides a common portion of each of the first and second coil elements with a capacitor in the common portion which forms part of the tuning capacitors of each of the first and second coil elements.

The pair of coils can be used as a single pair where the two signals produced thereby are processed in two separate channels; but more preferably where the signal processing system has a much larger number of channels, a series of such pairs can be used where each pair provides two respective signals for a respective pair of channels of the signal processing system. That is the first and second coils form a first pair of coils and there are provided additional pairs arranged in an array. Preferably the pairs are arranged each relative to the next pair in the partly overlapping relationship known to provide conventional decoupling such that each pair has portions thereof outside portions of the other.

In another arrangement, the conductor connecting the first and second coils provides two conductors connecting the first and second coils one of which is a direct conducting connection and the other of which has a capacitor therein. This arrangement is preferably used where each coil of the pair is only partly overlapping with the other coil the first and second coils are rectangular so as to overlap at a common square. The arrangement of overlap is not of the proportions which provide the conventional decoupling.

In addition the receive coil arrangement itself is an aspect of the present invention and comprises:

first and second coils arranged to be located adjacent the subject so as to receive the MR signal;
the first and second coils being arranged in a stacked relationship so as to be at least partly overlapped;
said at said first and second coils including tuning capacitors arranged to provide individually tuning of the first and second coils to a common resonant frequency for receiving said MR signal at said common frequency;
each of said first and second coils having output connectors arranged to communicate the respective MR signals therein to a signal processing system;
the first and second coils being connected by a conductor having a capacitor therein arranged such that the signals of the first and second coils are decoupled.

Thus, instead of using a single layer for the elements as in the current design, the stacked phased array coil design will multiple layers for the individual elements without increasing the overall thickness of the finished coil.

The SNR values will be the $SNR = \sqrt{n} \times SNR_0$ for the stacked phased array coils value, where SNR0 represents the SNR of a single layer design, where n is the number of layers. If n=2, the SNR will increase by 40%. If n=4, the SNR will be doubled.

This concept could be widely used in MR coils including:

MR Wireless coil either passive inductive wireless coil or active wireless coil as shown in the above US Application Serial Number 13/090816 filed April 20 2011 and 13/231004 filed September 13 2011. This corresponds to Canadian application 2753561;
Current MR phased array coil designs with either wired or wireless communication;
Current Transmit receive coil designs;
Current multi-channel transmit receive coil;
Volume coils, such as Quadrature Butterfly, Phased Array Volume, and possibly Birdcage designs;
Radiolucent coil;
Internal coil, such as endorectal for prostrate, colon, or cervix examinations, cardiac catheter; and

The coil construction can be used in the following applications: Head and neck, Upper body and Organs, Breast, Joints and Extremities.

The arrangement described herein can provide one or more of the following advantages and features:

The stacked phased array coil design can double the number of element without reducing the size of each element for better imaging penetration and increased SNR;
The stacked phase array design can be applied to any MRI coil design;
Tuning and matching the stacked phased array design does not require addition steps compared to the traditional phased array imaging coils; and
The imaging quality can be improved with the same scan time, or the scan time can halved with the same imaging quality as traditional designs.

In an tested arrangement, 3T stacked inductive wireless coil imaging and single loop inductive wireless coil were tested, as in Application Serial Number 13/090816, and the stacked coil produced a 35% increase in SNR compared to the single loop. Therefore, very good image quality and penetration were achieved.

BRIEF DESCRIPTION OF THE DRAWINGS

One embodiment of the invention will now be described in conjunction with the accompanying drawings in which:

Figure 1 is a schematic illustration of an MRI system including a first embodiment of the present invention.
Figure 2 is a schematic illustration of an MRI system including a second embodiment of the present invention.
Figure 3 is a schematic illustration of the head coil of Figure 2 along the lines 3-3.
Figure 4 is a schematic plan illustration of a top flexible portion of the head coil of Figure 2.
Figure 5 is a top plan view of a first embodiment of stacked coil according to the present invention.
Figure 6 is a top plan view of a second embodiment of stacked coil according to the present invention.
Figure 7 is a cross-sectional view along the lines 7-7 of Figure 5.
Figure 8 is a cross-sectional view similar to that of Figure 7 showing coils formed from wire.
Figure 9 is a cross-sectional view of the coils of Figure 8 showing the coils formed from wire.
Figure 10 is a top plan view of a third embodiment of stacked coil according to the present invention.

In the drawings like characters of reference indicate corresponding parts in the different figures.

DETAILED DESCRIPTION

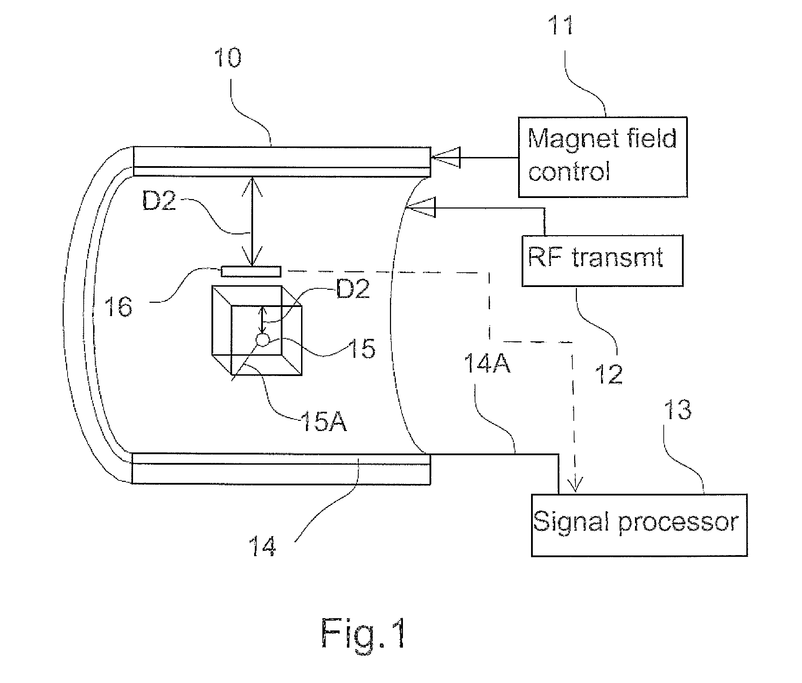

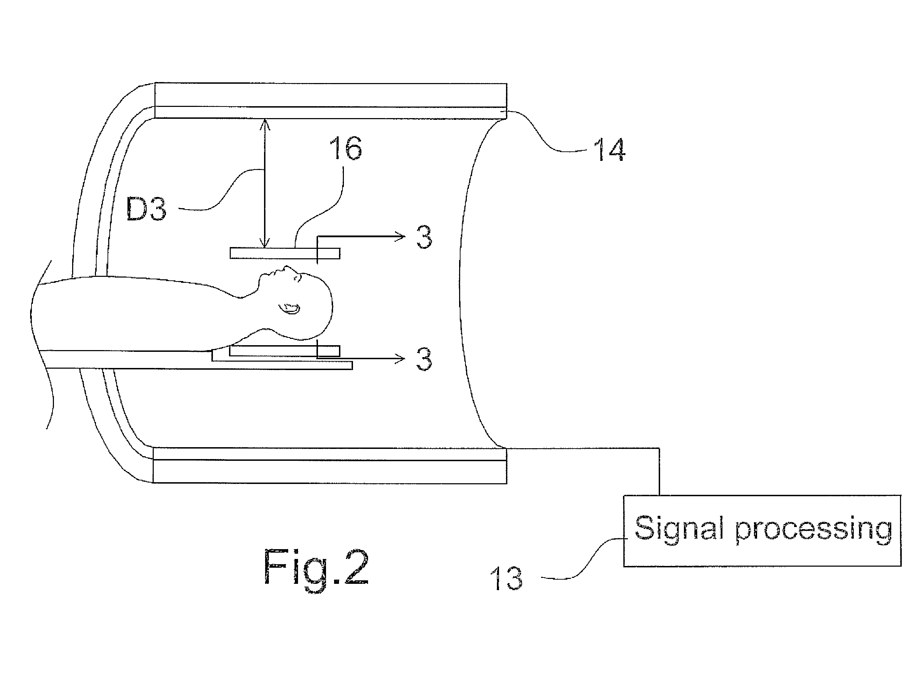

The apparatus shown in Figure 1 to 4 is taken from US Application Serial Number 13/090816 filed April 20 2011 and from 13/231004 filed September 13 2011, which corresponds to Canadian application 2753561 filed September 12 2011 and published December 14 2011.
This apparatus for MR imaging of a subject includes a conventional cylindrical MR magnet 10 operable by a field control system to generate a variable magnetic field to be applied to the subject.
The MR system includes an RF transmit arrangement 12 for generating RF pulses in a transmit stage to be applied to the subject to be imaged and a receive arrangement for acquiring the MR signal in a receive stage with a signal processing system 13 for receiving the MR signal for carrying out signal processing by which an image is generated. As is well known, the subject generates an MR signal in response to the magnetic field and the RF signal applied which is detected and processed to generate an image. The arrangement is well known and a suitable system is available from Siemens.
Typically the magnet 10 carries an RF coil known as a body coil 14 which is mounted on the cylindrical magnet housing so as to surround the patient. This is usually used as the transmit coil. However separate transmit can be used. The body coil can also operate as the receive coil. However again separate receive coils can be used. The transmit and receive coils can be the same coils or can be provided by separate coils.
In the first embodiment shown in Figure 1, the transmit coil is defined by the body coil 14. The receive coil arrangement comprises an innermost coil loop 15 located inside the body of the patient. This is inserted by a suitable support 15A which moves the coil 15 to the required location within the patient, for example within the heart or other organ to be imaged. The receive coil arrangement further comprises a first outer coil 16 located adjacent to the innermost coil 15 but outside the body. The coil 16 can be formed by a single loop but more preferably by a phased array of loops. The receive coil arrangement further comprises a second outer coil defined by the body coil 14 surrounding the coil 16. In other arrangements a separate coil can be used for the second outer coil. In any case, the second outer coil has a signal communication cable 14A connected to the signal processing system 13 for transferring the MR signal therein to the signal processing system.

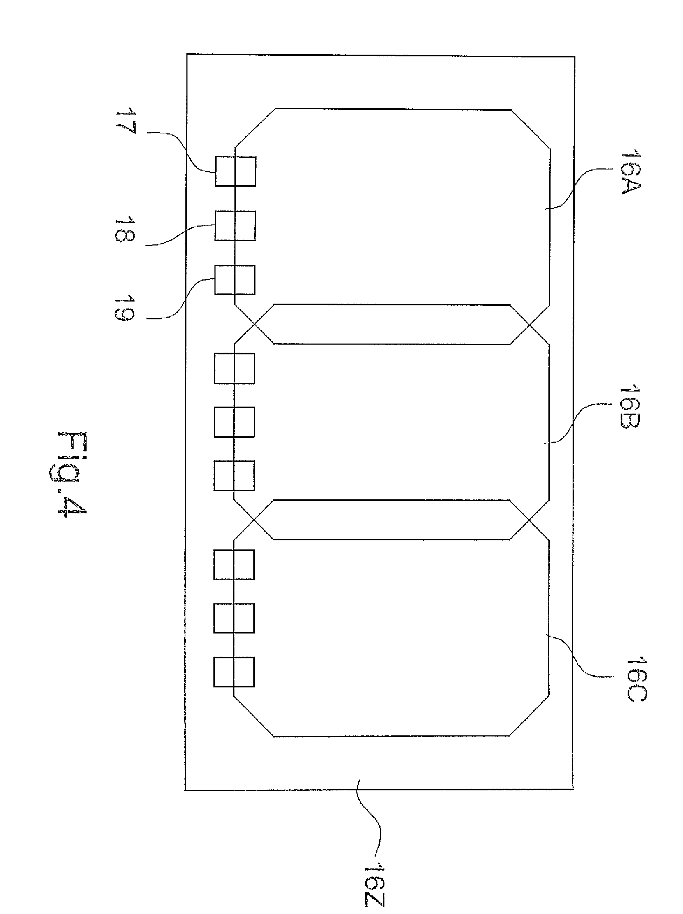

In Figure 4, a plan view is provided on the coil 16 which in this arrangement is formed by a phased array of loops 16A, 16B, 16C etc. All of the loops of the coils 15, 16 and 14 are individually tuned by a tuning component such as capacitors schematically indicated at 17 to a common resonant frequency for receiving said MR signal using conventional tuning devices well known to a person skilled in the art.
All of the coil loops of the coils 15 and 16 which act only in the receive stage and do not transmit the applied RF pulses in the transmit stage have therein an arrangement schematically indicated at 18, such as a passive block circuit with capacitors, inductor and pin diodes, to halt current flow therein during the transmit stage so as to prevent the presence of said all coil loops from interfering with the RF pulses during the transmit stage. Devices of this type are known so that explanation of the operation is not necessary.

In a conventional arrangement, the loop of the innermost coil 15 is arranged to communicate the MR signal therein to the signal processing system by a cable connection 14B.

In the arrangement of the above application, the loop of the innermost coil 15 is arranged to communicate the MR signal therein to the signal processing system through the loops of the first outer coil 16 and through the second outer coil 14 by inducing the MR signal onto the coil 15 and therefrom onto the coil 14.

Typically in this arrangement, the coil 16 is as close as possible to the exterior of the patient and this in turns communicates inductively to the body coil (or other coil) around the patient.

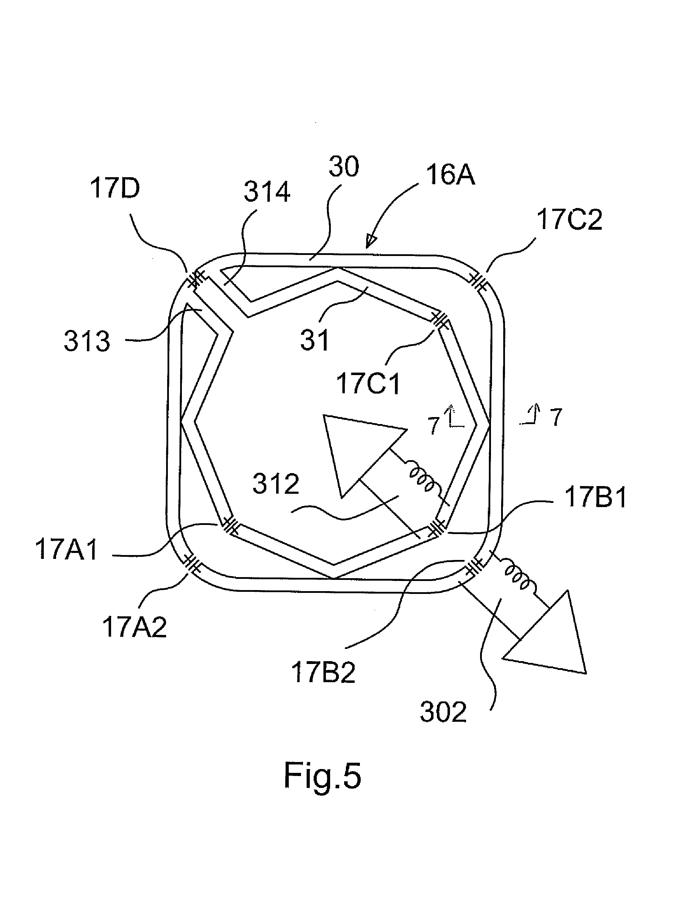

In the present arrangement, the receive coil arrangement of Figure 4 is modified so that each coil element 16A, 16B etc, instead of being defined by a single coil loop is formed by a pair of coil elements 30 and 31 shown in Figure 5. This includes first and second coils 30 and 31 which are as described above arranged to be located adjacent the subject so as to receive the MR signal.

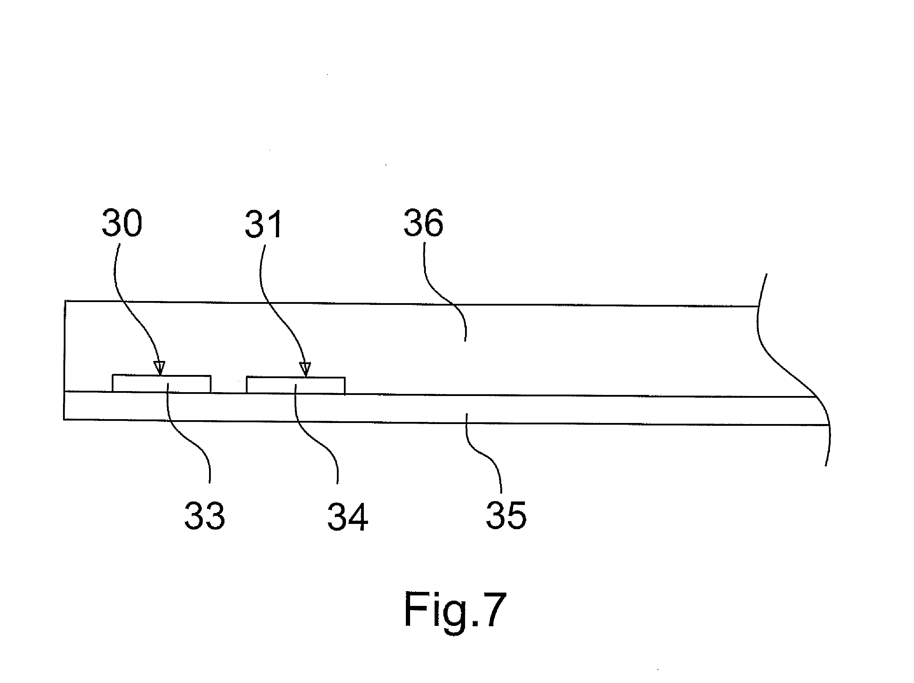

The first and second coils 30 and 31 are arranged in a stacked relationship so as to be at least partly overlapped. In this embodiment, the coils 30 and 31 are arranged to lie in a common plane as shown in Figure 7; furthermore, the stacked coil elements 30 and 31 could also be partially overlapped. Thus the conductors 33 and 34 forming the coils are flat strip conductors of a conventional arrangement using a copper trace on an insulating support board 35. As is conventional the components 17, 18 and 19 necessary for the operation of the coil are also formed as traces or components mounted on the board 35. In particular the tuning capacitors 17 of the coil 31 are shown as separate capacitors 17A1, 17B1, 17C1 and 17D and the tuning capacitors 17 of the coil 30 are shown as separate capacitors 17A2, 17B2, 17C2 and 17D.

Thus it will be noted that a portion 301 of the coils is common to both coils 30 and 31 and contains a capacitor 17D which is therefore common to both.

The tuning capacitors of each coil are arranged using known techniques to provide individually tuning of the first and second coils to a common resonant frequency for receiving the MR signal at the common frequency.

Each of the coils is arranged to communicate the respective MR signals therein to the signal processing system 13 by separate connecting cable 302 and 312 such that the respective signals are processed in separate channels of the signal processing system. Further details of the coil and its capacitors and signal communication system are shown in US Application 12/546148 filed August 24 2009 and published Feb.24 2011.

The values of the tuning capacitors and the capacitor 17D of the common portion of each of the first and second coils are selected to provide the required tuning to the required frequency and the decoupling of the mutual inductance so that the signals are decoupled and can be analyzed independently in separate channels of the processing system.

The values are selected using conventional techniques and practice can be obtained by empirical observations.

In one example, the coils have the following characteristics and the values of the capacitors are as follows:

In Figure 5 as an example: the outer coil shape is squared with side length of 17 cm, the inner coil shape is octagonal with side length of 5.5 cm. Both coil elements are tuned at resonance frequency of 63.65MHz. for Siemens 1.5T MR systems. A passive decoupling circuit is implemented to form a blocking circuit during transmit stage in this coil. The capacitor value are listed in following table.

| Capacitor number | 17A1 | 17B1 | 17C1 | 17D | 17A2 | 17B2 | 17C2 |
|---|---|---|---|---|---|---|---|
| Value (pF) | 27 | 20+(4.5~20) | 27 | 4.5~20 | 15 | 12+(4.5~20) | 15 |

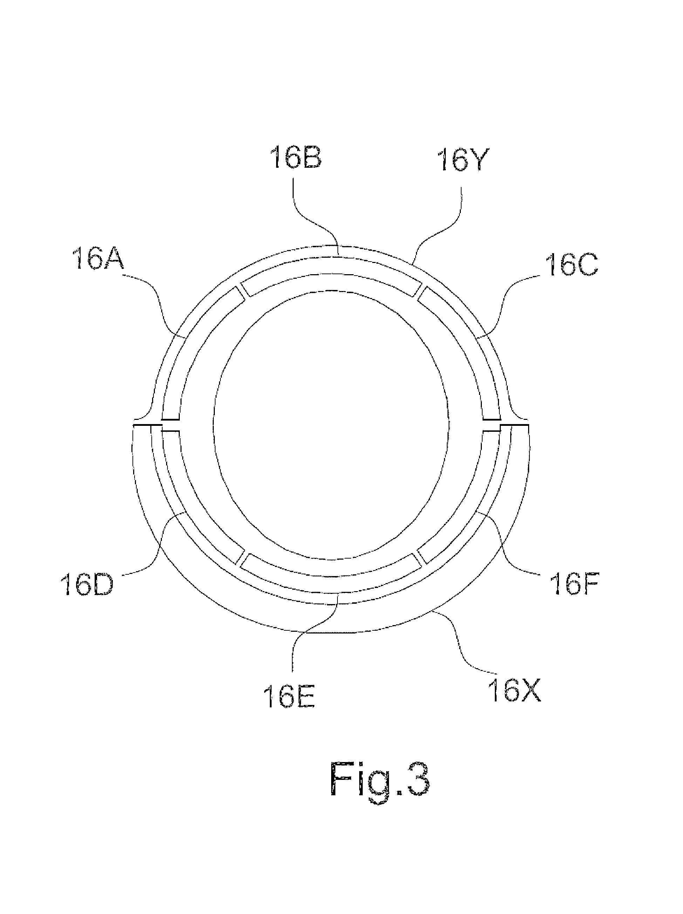

As shown in Figure 7, the coils lie in a common surface and form surface coils contained in a common insulating material allowing the structure to be arched in shape to fit over the patient as shown in Figure 3. In addition the surface coil assembly can be rigid or flexible. Furthermore, the wireless inductive coil version of the stacked coil can be sterilizable.

As shown in Figure 5, the first and second coils are shaped to define substantially the same transverse dimensions for same depth penetration. Thus one of the coils 30 is generally square in plan with the capacitors at the corners. The other coil 31 is generally circular or octagonal and located wholly within the outer coil so that it approaches closely to the outer coil 30 only at four individual locations so as to reduce the capacitive coupling therebetween. Thus in Figure 5 the first and second coils are arranged so that one lies wholly within or inside the other so that there are no crossing conducts and no portions where the inner coil lies outside the outer coil.

Thus the first and second coils are of different shape in plan so that the conductors thereof do not follow the same path. This allows the coils to be formed of the conventional flat strip material while providing no locations where the conductors cross and minimizing the capacitive connection therebetween.

However the coils when measured in the transverse direction are substantially equal in width at the locations of closest approach and it is this dimension which governs the penetration depth of the imaging, as is known.

In order to provide the common portion 301, the inner coil 31 is connected to the outer coil by two legs 313 and 314 so that the common portion is located at the outer coil 30. It will be appreciated that the common portion 301 can be located at the inner coil 31.

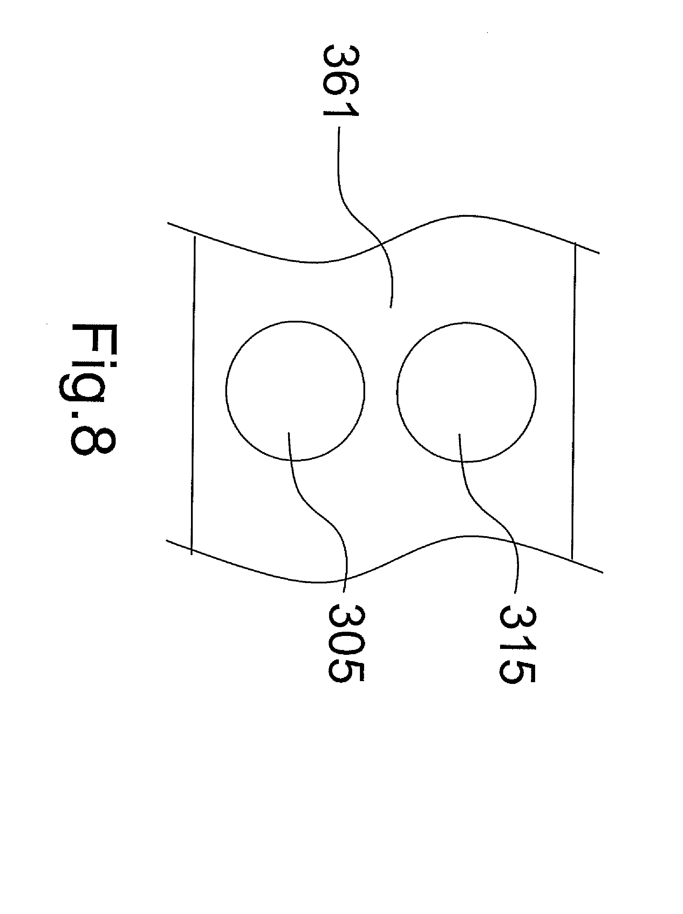

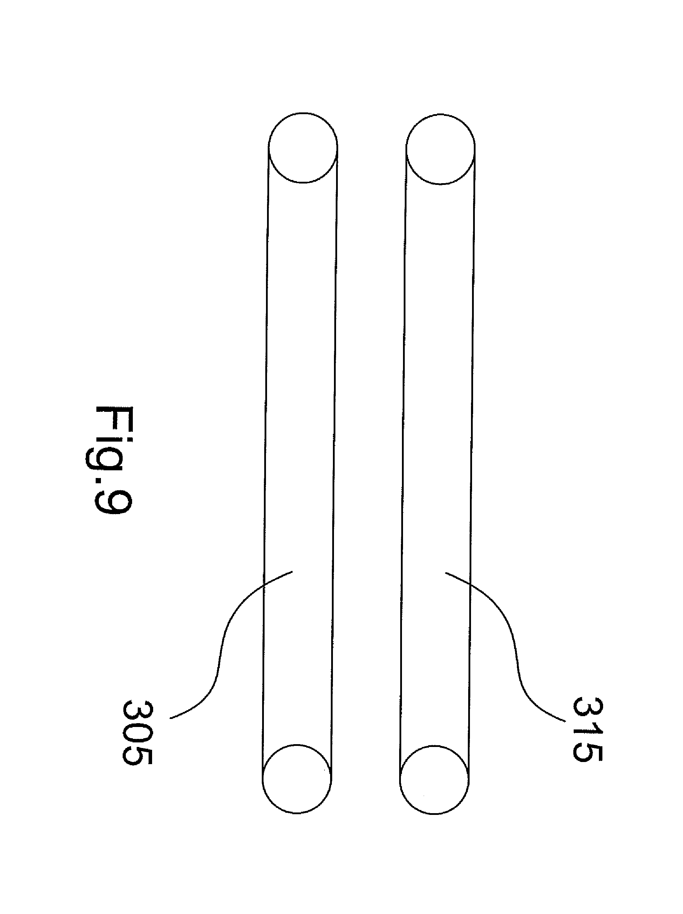

In the arrangement shown in Figures 8 and 9, the first and second coils 305 and 315 are each formed by conductors which are wire, that is they have a cross-section of the conductor which is circular or non-rectangular so as to reduce the capacitive coupling therebetween. This allows the conductors to be directly overlying with an insulating material 361 therebetween. As shown in Figure 8, the curvature of the surfaces of the conductors reduces the capacitive connection.

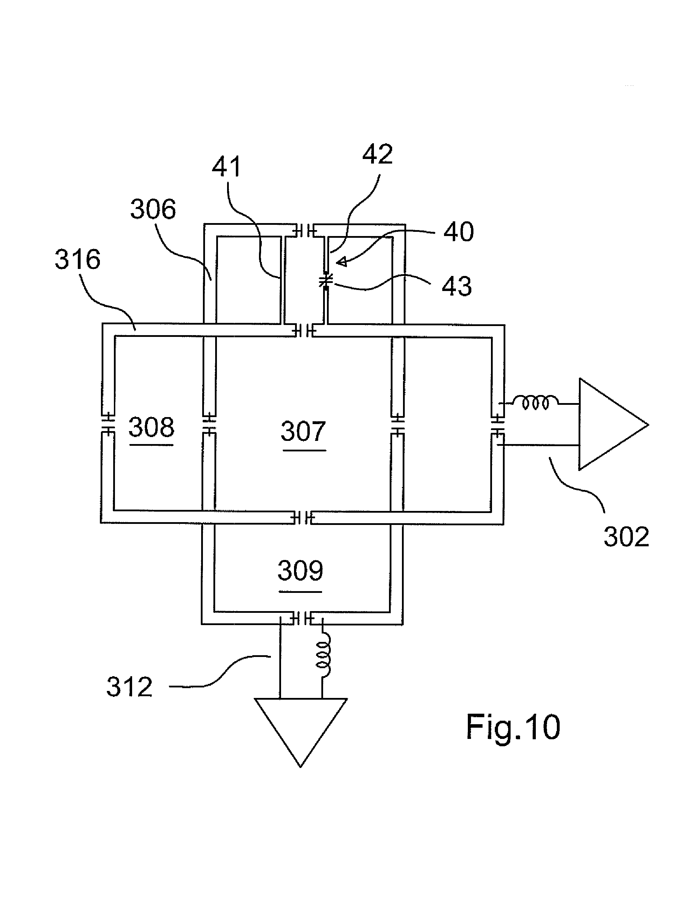

As shown in Figure 10, an alternative embodiment is provided in which the coils 306 and 316 are only partially overlapping defining a central square overlapped section 307 and two non-overlapping sections 308 and 309. In this case again the mutual inductance is decoupled by the conductor arrangement 40 connecting the first and second coils 306, 316 provides two conductors 41 and 42 connecting the first and second coils one of which is a short and the other of which has a capacitor 43 therein.

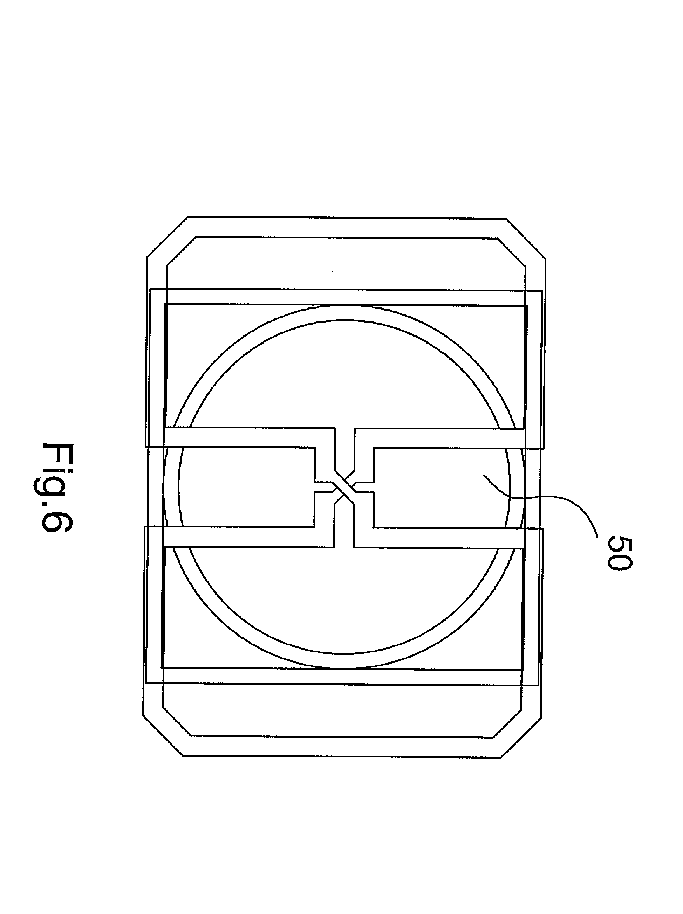

As previously explained the first and second coils form a first pair of coils and wherein there are provided additional pairs arranged in an array or partly overlapping pairs where each pair provides two respective signals for a respective pair of channels of the signal processing system. This can provide separate channels for the MRI system, including the signal processing system which can be two channels up to the limits of the system. By using a signal hardware combiner, the number of the coil elements can be further increased.. In addition the paired coils can be formed of three or more overlying coil elements so as to provide further additional channels. In addition the paired coils can be combined with the known construction of a butterfly coil which could be a single layer or a stacked element coil 50 shown in Figure 6 which is known by its construction to decouple from a single loop surface coil.

The two layer inductive stacked phased array coil design was developed as a proof of concept. The following table described the measured SNR test result on a 1900ml bottle phantom in a 3T MR imaging system. The ratio is SNR of the stacked coil divided by the SNR of the single coil.

| Coil | Signal (M) | Noise (SD) | SNR | Ratio |
|---------|------------|------------|-------|-------|
| Single | 806.4 | 5.0 | 161.3 | N/A |
| Stacked | 955.1 | 4.4 | 217 | 1.35 |

**Claims**

1. Apparatus for MR imaging of a subject comprising
   a MR magnet to generate a magnetic field to be applied to the subject;
   an RF transmit coil arrangement for generating an RF pulse in a transmit stage to be applied to the subject to be imaged such that the subject generates an MR signal in response to the magnetic field and the RF pulse applied;
   a receive coil arrangement for acquiring MR signals in a receive stage;
   and a signal processing system having a plurality of separate channels for receiving the MR signals for carrying out signal processing in the separate channels by which an image is generated;
   the receive coil arrangement comprising:

   first and second coils arranged to be located adjacent the subject so as to receive the MR signal;
   the first and second coils being arranged in a stacked relationship so as to be at least partly overlapped;
   said at said first and second coils including tuning capacitors arranged to provide individually tuning of the first and second coils to a common resonant frequency for receiving said MR signal at said common frequency;
   each of said first and second coils being arranged to communicate the respective MR signals therein to the signal processing system such that the respective signals are processed in separate channels of the signal processing system;
   the first and second coils being connected by a conductor arranged such that the signals of the first and second coils are decoupled.

2. The apparatus according to claim 1 wherein the first and second coils are decoupled by cancelling mutual inductance therebetween.

3. The apparatus according to claim 1 or 2 wherein the first and second coils comprise surface coils.

4. The apparatus according to any one of claims 1 to 3 wherein the first and second coils lie substantially in a common surface.

5. The apparatus according to any one of claims 1 to 4 wherein the common surface is in a common plane.

6. The apparatus according to any one of claims 1 to 5 wherein the first and second coils are shaped to define substantially the same transverse dimensions for same depth penetration.

7. The apparatus according to any one of claims 1 to 6 wherein the first and second coils are arranged so that one lies inside the other.

8. The apparatus according to claim 7 wherein the first and second coils are of different shape in plan so that the conductors thereof do not follow the same path.

9. The apparatus according to any one of claims 1 to 8 wherein the first and second coils are each formed by conductors which are wire.

10. The apparatus according to claim 9 wherein the wire conductors of the first and second coils are stacked so as to be directly overlying.

11. The apparatus according to any one of claims 1 to 10 wherein the conductor connecting the first and second coils provides a common portion of each of the first and second coils including a capacitance of in the common portion which forms part of the tuning capacitors of each of the first and second coils and is arranged to provide the decoupling.

12. The apparatus according to any one of claims 1 to 11 wherein the conductor connecting the first and second coils provides two conductors connecting the first and second coils one of which is a short and the other of which has a capacitor therein.

13. The apparatus according to any one of claims 1 to 12 wherein the first and second coils form a first pair of coils and wherein there are provided additional stacked coil pairs arranged in an array, or partly overlapping pairs where each pair provides two respective signals for a respective pair of channels of the signal processing system.

14. The apparatus according to any one of claims 1 to 13 wherein the first and second coils are arranged to be partly overlapping such that each has portions thereof outside portions of the other.

15. The apparatus according to claim 14 wherein the first and second coils are rectangular so as to overlap at a common square.

Fig.1

Fig.2

16B    16Y

16A    16C

16D    16F

16E    16X

Fig.3

Fig.4

17

18

19

16A

16B

16C

16Z

Fig.5

Fig.6

50

EP 2 589 976 A1

14

Fig.7

EP 2 589 976 A1

**315**

**361**

**305**

Fig.8

Fig.9

Fig.10

Europäisches
Patentamt
European
Patent Office
Office européen
des brevets

**EUROPEAN SEARCH REPORT**

Application Number

EP 12 18 9898

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/076377 A1 (FINDEKELEE CHRISTIAN [DE] FINDEKLEE CHRISTIAN [DE]) 19 March 2009 (2009-03-19) * paragraph [0018] - paragraph [0021] * * paragraph [0028] * * figures 1, 6 * | 1-15 | INV. G01R33/3415 G01R33/36 G01R33/34 |
| X | US 6 900 637 B1 (SEEBER DEREK A [US]) 31 May 2005 (2005-05-31) * column 3, line 20 - column 4, line 24 * * figures 1, 2 * | 1-15 | |
| X | US 2007/085634 A1 (DU JIAN-JUN [CN] ET AL) 19 April 2007 (2007-04-19) * paragraph [0022] - paragraph [0027] * * figure 5 * | 1-15 | |
| X | US 2008/129296 A1 (FISCHER HUBERTUS [DE] ET AL) 5 June 2008 (2008-06-05) * paragraph [0007] - paragraph [0018] * * paragraph [0042] - paragraph [0048] * * figures 1, 2 * | 1-15 | |
| X | US 2007/016003 A1 (PIRON CAMERON A [CA] ET AL PIRON CAMERON ANTHONY [CA] ET AL) 18 January 2007 (2007-01-18) * paragraph [0107] * * figures 8G, 8H * | 1-15 | TECHNICAL FIELDS SEARCHED (IPC) G01R |
| Y | US 2005/073309 A1 (WILLIAMS NEIL R [US] ET AL) 7 April 2005 (2005-04-07) * paragraph [0052] * * figures 4A-4C * | 1-15 | |
| Y | US 2002/169374 A1 (JEVTIC JOVAN [US]) 14 November 2002 (2002-11-14) * the whole document * | 1-15 | |

-/--

The present search report has been drawn up for all claims

| Place of search | Date of completion of the search | Examiner |
|---|---|---|
| Munich | 6 February 2013 | Streif, Jörg Ulrich |

Europäisches
Patentamt

European
Patent Office

Office européen
des brevets

**EUROPEAN SEARCH REPORT**

Application Number

EP 12 18 9898

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2009/096456 A1 (BIBER STEPHAN [DE] ET AL) 16 April 2009 (2009-04-16) * the whole document * ----- | 1-15 | |

TECHNICAL FIELDS SEARCHED (IPC)

The present search report has been drawn up for all claims

| Place of search | Date of completion of the search | Examiner |
|---|---|---|
| Munich | 6 February 2013 | Streif, Jörg Ulrich |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 12 18 9898

This annex lists the patent family members relating to the patent documents cited in the above-mentioned European search report.
The members are as contained in the European Patent Office EDP file on
The European Patent Office is in no way liable for these particulars which are merely given for the purpose of information.

06-02-2013

| Patent document cited in search report | | Publication date | Patent family member(s) | | Publication date |
|---|---|---|---|---|---|
| US 2009076377 | A1 | 19-03-2009 | CN<br>EP<br>JP<br>US<br>WO | 101427150 A<br>2016436 A1<br>2009534161 A<br>2009076377 A1<br>2007124247 A1 | 06-05-2009<br>21-01-2009<br>24-09-2009<br>19-03-2009<br>01-11-2007 |
| US 6900637 | B1 | 31-05-2005 | EP<br>US<br>WO | 1725885 A1<br>6900637 B1<br>2005093449 A1 | 29-11-2006<br>31-05-2005<br>06-10-2005 |
| US 2007085634 | A1 | 19-04-2007 | CN<br>US | 1940587 A<br>2007085634 A1 | 04-04-2007<br>19-04-2007 |
| US 2008129296 | A1 | 05-06-2008 | CN<br>DE<br>US | 101226230 A<br>102006055136 A1<br>2008129296 A1 | 23-07-2008<br>29-05-2008<br>05-06-2008 |
| US 2007016003 | A1 | 18-01-2007 | EP<br>EP<br>JP<br>US<br>US<br>WO | 2063776 A1<br>2096454 A2<br>2010501294 A<br>2007016003 A1<br>2012172704 A1<br>2008025146 A1 | 03-06-2009<br>02-09-2009<br>21-01-2010<br>18-01-2007<br>05-07-2012<br>06-03-2008 |
| US 2005073309 | A1 | 07-04-2005 | EP<br>JP<br>US | 1521094 A1<br>2005103308 A<br>2005073309 A1 | 06-04-2005<br>21-04-2005<br>07-04-2005 |
| US 2002169374 | A1 | 14-11-2002 | NONE | | |
| US 2009096456 | A1 | 16-04-2009 | DE<br>US | 102007047020 A1<br>2009096456 A1 | 16-04-2009<br>16-04-2009 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 13090816 A
- US 09081611 A
- US 13231004 A
- CA 2753561
- US 13231004 B
- US 12546148 B

**Non-patent literature cited in the description**

- **DANDAN LIANG et al.** Study on the Decoupling of Stacked Phased Array coils for magnetic resonance imaging. *Progress in Electromagnetics Research Symposium Proceedings Suzhou China,* 12 September 2011